# EUROPÄISCHE PATENTSCHRIFT

(11) **EP 2 549 843 B1**
(45) Veröffentlichungstag und Bekanntmachung des Hinweises auf die Patenterteilung: **27.05.2015**
(21) Anmeldenummer: 11174858.8
(22) Anmeldetag: 21.07.2011
(51) Int. Cl.: H05K 7/14

(54) **Verfahren zum Betrieb einer Ein-/Ausgabebaugruppe und Ein-/Ausgabebaugruppe**
Method for operating an input/put component and input/output component
Procédé de fonctionnement d'un composant d'entrée/sortie et composant d'entrée/sortie

(43) Veröffentlichungstag der Anmeldung: 23.01.2013
(73) Patentinhaber: Siemens Aktiengesellschaft, 80333 München (DE)
(72) Erfinder: Fischer, Peter, 92421 Schwandorf (DE)

(56) Entgegenhaltungen:
- EP-A2- 2 421 346
- DE-A1- 4 437 316

## Beschreibung

Die Erfindung betrifft ein Verfahren zum Betrieb einer Ein-/Ausgabebaugruppe der Steuerungstechnik mit einem Frontstecker, wobei über eine Vielzahl an einer Vorderseite des Frontsteckers angeordnete Anschlusselemente Signalleitungen entsprechend der Funktion der Ein-/Ausgabebaugruppe nach einer Verschaltungsvorgabe angeklemmt werden.

Des Weiteren betrifft die Erfindung eine Ein-/Ausgabebaugruppe der Steuerungstechnik ausgestaltet um einen Frontstecker aufzunehmen und Prozesswerte einzulesen, mit einem Feldbusanschluss.

Im Sinne der Erfindung wird unter Steuerungstechnik die Automatisierung und Steuerung von industriellen Anlagen über speicherprogrammierbare Steuerungen verstanden. Die Ein-/Ausgabebaugruppen sind dabei beispielsweise Signalbaugruppen einer speicherprogrammierbaren Steuerung, wobei die Signalbaugruppe eine Schnittstelle zu dem industriellen zu automatisierenden Prozess bildet. Die Ein-/Ausgabebaugruppen, welche als Signalbaugruppen ausgestaltet sind, können in Digital- und Analogbaugruppen unterschieden werden. Diese wiederum unterscheiden sich in einer Kanalzahl, Eingabe oder Ausgabe, Messart und Messbereich, Potentialtrennung, Diagnose- und Alarmfähigkeit. Ein Anschluss von Aktoren/Sensoren aus dem zu automatisierenden Prozess erfolgt über den Frontstecker. Ein-/Ausgabebaugruppe und Frontstecker arbeiten nach dem Stecker-/Dose-Prinzip zusammen.

Bei einem Austausch einer Ein-/Ausgabebaugruppe kann der Frontstecker von der zu tauschenden Baugruppe abgenommen werden, dabei bleibt die Verdrahtung der Signalleitungen an dem Frontstecker bestehen. Solch ein Austausch einer Baugruppe ist beispielhaft erforderlich wenn eine alte Baugruppe defekt ist und gegen eine neue funktionstüchtige Baugruppe getauscht werden muss. Bei einem Baugruppenaustausch kann es jedoch vorkommen, dass die Frontstecker verwechselt werden oder versehentlich eine auszutauschende Baugruppe herangezogen wird, die nicht mit der zuvor vorherrschenden Verschaltungsvorgabe übereinstimmt. Werden die Frontstecker bei einem Baugruppentausch verwechselt, so kann dies zu einer Fehlinterpretation der Prozessdaten führen. Um dies zu verhindern, ist eine Verwechslung der Frontstecker auszuschließen.

In der DE 195 147 68 A1 wird eine Lösung um eine Verwechslung der Frontstecker auszuschließen vorgeschlagen, hier beinhaltet der Frontstecker ein mechanisches Codierelement, welches in ein Gegenelement der passenden Ein-/Ausgabebaugruppe einsteckbar ist. Immer wenn das Codierelement und das Gegenelement übereinstimmen, lässt sich der Frontstecker in die Ein-/Ausgabebaugruppe stecken.

In der europäischen Patentanmeldung EP 2 421 346 A2 mit dem Anmeldedatum 22.02.2012 unter Beanspruchung des Prioritätsdatums 20.08.2010 der US 375587, welche nach dem Anmeldetag der vorliegenden Erfindung veröffentlicht wurde, wird eine Ein-/Ausgabebaugruppe und ein Frontstecker mit einer Schreib-/Leseeinheit zur Codierung offenbart.

Der Erfindung liegt nun die Aufgabe zugrunde, eine Codierung einer Ein-/Ausgabebaugruppe zu dem zugehörigen Frontstecker zu vereinfachen.

Die Aufgabe wird durch ein Verfahren zum Betrieb einer Ein-/Ausgabebaugruppe der Steuerungstechnik mit einem Frontstecker, wobei über eine Vielzahl an einer Vorderseite des Frontsteckers angeordnete Anschlusselemente Signalleitungen entsprechend der Funktion der Ein-/Ausgabebaugruppe nach einer Verschaltungsvorgabe angeklemmt werden, dadurch gelöst, dass beim erstmaligen Stecken des Frontsteckers in die Ein-/Ausgabebaugruppe über eine in der Ein-/Ausgabebaugruppe angeordnete erste Schreib-/Leseeinheit eine individuelle Zeichenfolge in eine in dem Frontstecker angeordnete zweite Schreib-/Leseeinheit drahtlos übertragen wird, wodurch eine eindeutige Zuordnung zwischen der Ein-/Ausgabebaugruppe und dem Frontstecker entsprechend der Verschaltungsvorgabe hergestellt wird. Die drahtlose Datenübertragung kann dabei beispielsweise über eine Nahfeldfunkverbindung, insbesondere über eine RFID-Funkverbindung, durchgeführt werden. Mit Vorteil kann somit auf ein mechanisches Codierelement verzichtet werden. Dieser Verzicht erleichtert die Konstruktion und die Fertigung einer solchen Ein-/Ausgabebaugruppe.

In einer weiterführenden Ausgestaltung des Verfahrens wird die individuelle Zeichenfolge in einem Konfigurationssystem für die Ein-/Ausgabebaugruppe und in eine im Frontstecker angeordnete Speichereinheit hinterlegt. Unter Konfigurationssystem ist beispielsweise ein Engineeringsystem der Automatisierungstechnik zu verstehen. In diesem Engineeringsystem können die Funktionalitäten von Ein-/Ausgabebaugruppen parametriert werden. Von Vorteil ist es hier, dass eine einmal parametrierte Ein-/Ausgabebaugruppe hinsichtlich ihrer Verschaltungsvorgabe eine individuelle Zeichenfolge erhält, welche zusätzlich in Konfigurationsdaten des Konfigurationssystems hinterlegt ist.

Um das Verfahren hinsichtlich eines Baugruppenaustausches weiter zu optimieren, wird für den Fall eines Austauschens der Ein-/Ausgabebaugruppe die alte Ein-/Ausgabebaugruppe vom Frontstecker getrennt und gegen eine neue Ein-/Ausgabebaugruppe getauscht, wobei vor dem Stecken des Frontsteckers in die neue Ein-/Ausgabebaugruppe, diese an das Konfigurationssystem angeschlossen wird und das Konfigurationssystem die individuelle Zeichenfolge in eine in der neuen Ein-/Ausgabebaugruppe angeordnete Speichereinheit schreibt.

Vorteilhafter Weise wird nach dem Zustecken des Frontsteckers in die neue Ein-/Ausgabebaugruppe über ein Prüfmittel geprüft, ob die in der neuen Ein-/Ausgabebaugruppe befindliche individuelle Zeichenfolge mit der in der Speichereinheit in dem Frontstecker hinterlegten individuellen Zeichenfolge übereinstimmt und für den Fall, dass die beiden individuellen Zeichenfolgen übereinstimmen, die neue Ein-/Ausgabebaugruppe ein Freischaltmittel aktiviert, welches über die Signalleitungen eingelesene Prozesswerte für gültig erklärt, andernfalls werden über das Freischaltmittel die Prozesswerte für ungültig erklärt und eine Diagnosemeldung abgesetzt.

Das Verfahren kann bei einer Ein-/Ausgabebaugruppe der Steuerungstechnik ausgestaltet um einen Frontstecker aufzunehmen und Prozesswerte einzulesen, wobei die Ein-/Ausgabebaugruppe mit einem Feldbusanschluss versehen ist, angewendet werden.

Demnach wird die eingangs genannte Aufgabe auch durch eine Ein-/Ausgabebaugruppe der Steuerungstechnik ausgestaltet um einen Frontstecker aufzunehmen und Prozesswerte einzulesen, mit einem Feldbusanschluss dadurch gelöst, dass eine erste Schreib-/Leseeinheit, welche ausgestaltet ist eine individuelle Zeichenfolge in eine in dem Frontstecker angeordnete zweite Schreib-/Leseeinheit drahtlos zu übertragen, wodurch eine eindeutige Zuordnung zwischen der Ein-/Ausgabebaugruppe und dem Frontstecker entsprechend einer Verschaltungsvorgabe hergestellt wird. Durch die erste Schreib-/Leseeinheit und die zweite Schreib-/Leseeinheit kann mit Vorteil auf die mechanischen Codierelemente und die Gegenelemente in den Ein-/Ausgabebaugruppen nach dem Stand der Technik verzichtet werden. Ein Verzicht auf zusätzliche mechanische Elemente macht eine Handhabung einer Ein-/Ausgabebaugruppe und eine Fertigung einfacher.

Eine weitere Ausgestaltung sieht vor, dass die Ein-/Ausgabebaugruppe mit einem Detektionsmittel ausgestaltet ist, welches mit der ersten Schreib-/Leseeinheit in Verbindung steht und bei einem erstmaligen Stecken des Frontstecker in die Ein-/Ausgabebaugruppe die erste Schreib-/Leseeinheit zum Übertragen der individuellen Zeichenfolge aktiviert.

In einer weiteren Ausgestaltung ist der Feldbusanschluss der Ein-/Ausgabebaugruppe derart ausgestaltet, dass im Falle eines Austauschens der Ein-/Ausgabebaugruppe, wobei die alte Ein-/Ausgabebaugruppe vom Frontstecker getrennt wird und gegen eine neue Ein-/Ausgabebaugruppe getauscht wird, die neue Ein-/Ausgabebaugruppe über den Feldbusanschluss der neuen Ein-/Ausgabebaugruppe an ein Konfigurationssystem anschließbar ist, wobei über den Feldbusanschluss die individuelle Zeichenfolge der alten Ein-/Ausgabebaugruppe, welche in dem Konfigurationssystem hinterlegt ist, in eine Speichereinheit der neuen Ein-/Ausgabebaugruppe weiterleitet. Nun ist die neue Ein-/Ausgabebaugruppe im Besitz der individuellen Zeichenfolge gemäß der Verschaltungsvorschrift für den ihr zugeordneten Frontstecker. Eine vorteilhafte Kommunikation zwischen Ein-/Ausgabebaugruppe und Frontstecker erfolgt dabei verdrahtlos, vorzugsweise über eine RFID-Verbindung. Durch diese drahtlose Kommunikation sind keine zusätzlichen Steckkontakte für Codierungen erforderlich. Auch ist es aufgrund der elektronischen Codierung über eine individuelle Zeichenfolge möglich nahezu beliebig viele Codierungen zu wählen. Auch ist es denkbar durch eine Hersteller-ID (Herstelleridentifikationsmerkmal) ein Einstecken von Frontsteckern anderer Hersteller, beispielsweise von Plagiat-Produkten, zu verhindern. Denn trägt der Frontstecker nicht die passende Hersteller-ID, so wird er von der Ein-/Ausgabebaugruppe nicht akzeptiert.

In einer weiteren Ausgestaltung ist die Ein-/Ausgabebaugruppe mit einem zwischen dem Feldbusanschluss und der Speichereinheit angeordneten Filtermittel versehen, dabei ist das Filtermittel ausgestaltet, die individuelle Zeichenfolge aus einem vorherrschenden Telegrammverkehr aus dem Feldbus herauszufiltern. Ein Feldbus der Automatisierungstechnik kann beispielsweise ein Profibus oder ein Profinet sein.

Weiterhin umfasst die Ein-/Ausgabebaugruppe ein Prüfmittel und ein Freischaltemittel, wobei das Prüfmittel ausgestaltet ist zu Prüfen, ob die in der Ein-/Ausgabebaugruppe hinterlegte individuelle Zeichenfolge mit der in dem Frontstecker hinterlegten individuellen Zeichenfolge übereinstimmt, wobei das Freischaltemittel ausgestaltet ist bei Übereinstimmung der individuellen Zeichenfolgen die Prozesswerte für gültig zu erklären, andernfalls die Prozesswerte für ungültig zu erklären und eine Diagnosemeldung abzusetzen.

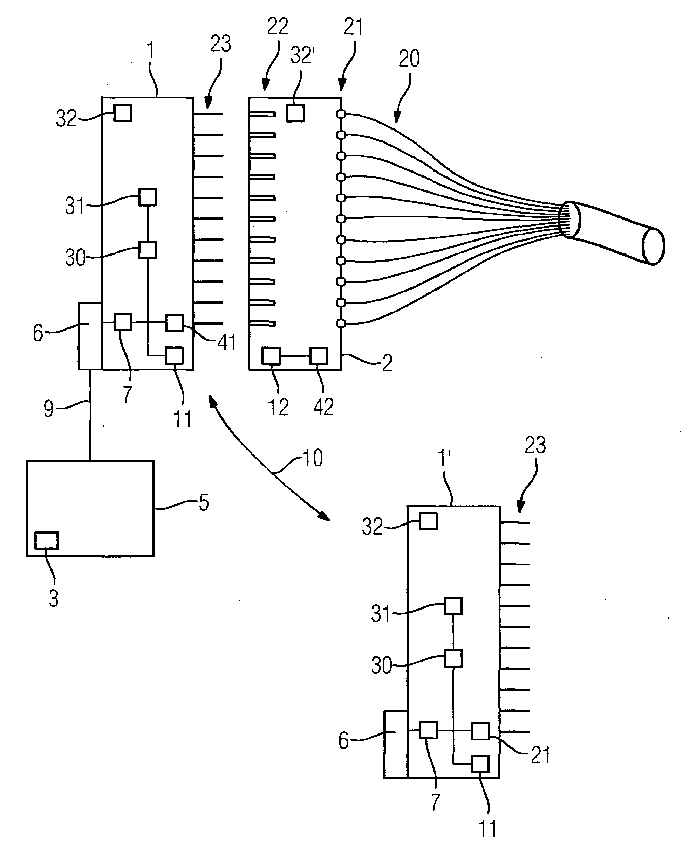

In der Zeichnung ist ein Ausführungsbeispiel der Erfindung näher beschrieben.

Die Figur zeigt eine Ein-/Ausgabebaugruppe im Austausch mit einer anderen Ein-/Ausgabebaugruppe. Gemäß der Figur ist eine Ein-/Ausgabebaugruppe 1 ausgestaltet, um einen Frontstecker 2 aufzunehmen. Für die Aufnahme des Frontsteckers 2 weist die Ein-/Ausgabebaugruppe 1 eine Messerleiste 23 mit Kontaktstiften auf, wobei im Frontstecker 2 eine Buchsenleiste 22 mit entsprechenden Kontaktbuchsen das Gegenstück zu der Messerleiste 23 bildet. Um Signalleitungen 20 an den Frontstecker 2 anzuschließen, weist der Frontstecker 2 Anschlusselemente 21 auf. Um die über die Signalleitungen 20 eingelesenen Prozesswerte an ein übergeordnetes Automatisierungssystem oder an ein Konfigurationssystem 5 weiterzugeben, weist die Ein-/Ausgabebaugruppe 1 einen Feldbusanschluss 6 auf.

Da die Signalleitungen gemäß einer Verschaltungsvorgabe über die Anschlusselemente 21 an den Frontstecker 2 angeklemmt sind und jeder Klemmpunkt des Frontsteckers 2 über die entsprechenden Buchsenkontakte der Buchsenleiste 22 an die entsprechenden Messerkontakte der Messerleiste 23 geführt werden und die Ein-/Ausgabebaugruppe 1 darauf parametriert ist an jedem Messerkontakt ein spezielles Signal zu empfangen, müssen die Ein-/Ausgabebaugruppe 1 und der Frontstecker 2 aufeinander abgestimmt sein. Das bedeutet es kann nicht eine beliebige Baugruppe an einen beliebigen Stecker gesteckt werden, dies würde u.U. zu Fehlinterpretationen der Signale führen.

Um ein versehentliches Stecken eines "falschen" Steckers oder einer "falschen" Ein-/Ausgabebaugruppe 1 zu vermeiden, weist die Ein-/Ausgabebaugruppe 1 eine erste Schreib-/Leseeinheit 11 auf, diese ist ausgestaltet, eine individuelle Zeichenfolge in eine in dem Frontstecker 2 angeordnete zweite Schreib-/Leseeinheit 12 drahtlos zu übertragen, wodurch eine eindeutige Zuordnung zwischen der Ein-/Ausgabebaugruppe 1 und dem Frontstecker 2 entsprechend der notwendigen Verschaltungsvorgabe hergestellt wird.

Um eine erstmalige Identifizierung des Frontsteckers 2 durchzuführen, ist die Ein-/Ausgabebaugruppe 1 mit einem Detektionsmittel 7 versehen, das Detektionsmittel 7 steht mit der ersten Schreib-/Leseeinheit 11 in Verbindung und ist derart ausgestaltet, dass bei einem erstmaligen Stecken des Frontsteckers 2 in die Ein-/Ausgabebaugruppe 1 das Detektionsmittel 7 dieses Stecken registriert und die erste Schreib-/Leseeinheit 11 veranlasst die individuelle Zeichenfolge in die zweite Schreib-/Leseeinheit 12 des Frontsteckers 2 zu übertragen. Ist diese Übertragung der individuellen Zeichenfolge erfolgreich vonstatten gegangen, so wird die übertragene individuelle Zeichenfolge in eine in dem Frontstecker 2 angeordnete zweite Speichereinheit 42 abgespeichert. Auch wird die individuelle Zeichenfolge in eine in der Ein-/Ausgabebaugruppe 1 angeordnete erste Speichereinheit 41 abgespeichert.

In einem Konfigurationssystem 5, welches über einen Feldbus 9 an einen Feldbusanschluss 6 an die Ein-/Ausgabebaugruppe 1 angeschlossen ist, wird die individuelle Zeichenfolge in einem Ablageplatz 3 in dem Konfigurationssystem 5 hinterlegt.

Soll nun ein Baugruppenaustausch der Ein-/Ausgabebaugruppe 1, beispielsweise weil diese defekt ist, erfolgen, so kann die defekte, alte Ein-/Ausgabebaugruppe 1 gegen eine neue, voll funktionierende Ein-/Ausgabebaugruppe 1' gewechselt werden. Der Austausch dieser beiden Baugruppen ist durch die Doppelpfeillinie Austausch 10 angedeutet.

Bei einem Austausch 10 wird der Frontstecker 2 von der alten Ein-/Ausgabebaugruppe 1 gezogen. Auch wird der Feldbusanschluss 6 von der alten Ein-/Ausgabebaugruppe 1 gelöst. Die Signalleitungen 20 können mit Vorteil in ihrer verschalteten Konfiguration an dem Frontstecker 2 belassen werden.

Die neue, funktionstüchtige Ein-/Ausgabebaugruppe 1' wird nun an die Stelle der alten defekten Ein-/Ausgabebaugruppe 1 gesetzt. Dabei wird zunächst der Feldbus 9 an den Feldbusanschluss 6 der neuen Ein-/Ausgabebaugruppe 1' angeschlossen.

Da der Feldbus 9 mit dem Konfigurationssystem 5 verbunden ist, kann eine für die alte Baugruppe geltende individuelle Zeichenfolge aus dem Datenspeicher des Konfigurationssystems 5 entnommen werden und in die neue Ein-/Ausgabebaugruppe 1' übertragen werden. Die individuelle Zeichenfolge wird in der ersten Speichereinheit 41 der neuen Ein-/Ausgabebaugruppe 1' abgelegt. Es sei angemerkt, dass die alte Ein-/Ausgabebaugruppe 1 und die neue Ein-/Ausgabebaugruppe 1' identisch aufgebaut sind, gleiche Bezugszeichen haben somit gleiche Funktionalitäten.

Soll nun die neue Ein-/Ausgabebaugruppe 1' in Betrieb gehen, so wird zunächst der Frontstecker 2 auf die neue Ein-/Ausgabebaugruppe 1' gesteckt. Um zu prüfen, ob die neue Ein-/Ausgabebaugruppe 1' zu dem Frontstecker 2 passt, weist die neue Ein-/Ausgabebaugruppe 1' ein Prüfmittel 30 und ein Freischaltmittel 31 auf, wobei das Prüfmittel 30 ausgestaltet ist zu prüfen, ob die in der Ein-/Ausgabebaugruppe 1' hinterlegte individuelle Zeichenfolge mit der in dem Frontstecker 2 hinterlegten individuellen Zeichenfolge übereinstimmt, wobei das Freischaltmittel 31 ausgestaltet ist bei Übereinstimmung der individuellen Zeichenfolgen, die Prozesswerte für gültig zu erklären, andernfalls die Prozesswerte für ungültig zu erklären und eine Diagnosemeldung abzusetzen.

Weiterhin kann die Ein-/Ausgabebaugruppe 1' oder auch die Ein-/Ausgabebaugruppe 1 eine Herstellererkennung 32 aufweisen. Diese Herstellererkennung 32 dient dazu eine entsprechende Gegenkennung 32', welche im Frontstecker 2 angeordnet ist, auszulesen und zu vergleichen. Sollte ein Frontstecker 2 gesteckt werden, welcher nicht die entsprechende Gegenkennung 32' des Herstellers aufweist, so ist das Prüfmittel 30 weiterhin dazu ausgestaltet dieses zu registrieren und die Ein-/Ausgabebaugruppe 1 oder 1' zu blockieren, weil ein herstellerfremder Stecker an die Baugruppe angeschlossen werden soll.

## Patentansprüche

1. Verfahren zum Betrieb einer Ein-/Ausgabebaugruppe (1) der Steuerungstechnik mit einem Frontstecker (2), wobei über eine Vielzahl an einer Vorderseite des Frontsteckers (2) angeordnete Anschlusselemente Signalleitungen entsprechend der Funktion der Ein-/Ausgabebaugruppe (1) nach einer Verschaltungsvorgabe angeklemmt werden,
**dadurch gekennzeichnet, dass**
beim erstmaligen Stecken des Fronsteckers (2) in die Ein-/Ausgabebaugruppe (1) über eine in der Ein-/Ausgabebaugruppe (1) angeordnete erste Schreib-/Leseeinheit (11) eine individuelle Zeichenfolge in eine in dem Frontstecker (2) angeordnete zweite Schreib-/Leseeinheit (12) drahtlos übertragen wird, wodurch eine eindeutige Zuordnung zwischen der Ein-/Ausgabebaugruppe (1) und dem Frontstecker (2) entsprechend der Verschaltungsvorgabe hergestellt wird, wobei die individuelle Zeichenfolge (3) in einem Konfigurationssystem (5) für die Ein-/Ausgabebaugruppe (1) und in eine im Frontstecker (2) angeordnete Speichereinheit hinterlegt wird, wobei im Falle eines Austauschens der Ein-/Ausgabebaugruppe (1) die alte Ein-/Ausgabebaugruppe (1) vom Frontstecker (2) getrennt wird und gegen eine neue Ein-/Ausgabebaugruppe (1') getauscht wird, wobei vor dem Stecken des Frontsteckers (2) in die neue Ein-/Ausgabebaugruppe (1'), diese an das Konfigurationssystem (5) angeschlossen wird und das Konfigurationssystem (5) die individuelle Zeichenfolge in eine in der neuen Ein-/Ausgabebaugruppe (1') angeordnete Speichereinheit schreibt.

2. Verfahren nach Anspruch 1, wobei nach dem Zustecken des Frontsteckers (1) in die neue Ein-/Ausgabebaugruppe (1') über ein Prüfmittel (30) geprüft wird, ob die in der neuen Ein-/Ausgabebaugruppe (1') befindliche individuelle Zeichenfolge mit der in der Speichereinheit in dem Frontstecker (2) hinterlegten individuellen Zeichenfolge übereinstimmt und für den Fall, dass die beiden individuellen Zeichenfolgen übereinstimmen, die neue Ein-/Ausgabebaugruppe (1') ein Freischaltmittel (31) aktiviert, welches über die Signalleitungen eingelesene Prozesswerte für gültig erklärt, andernfalls werden über das Freischaltmittel (31) die Prozesswerte für ungültig erklärt und eine Diagnosemeldung abgesetzt.

3. Ein-/Ausgabebaugruppe (1) der Steuerungstechnik ausgestaltet um einem Frontstecker (2) aufzunehmen und Prozesswerte einzulesen, mit einem Feldbusanschluss (6),
**gekennzeichnet durch**
eine erste Schreib-/Leseeinheit (11), welche ausgestaltet ist eine individuelle Zeichenfolge in eine in dem Frontstecker (2) angeordnete zweite Schreib-/Leseeinheit (12) drahtlos zu übertragen, wodurch eine eindeutige Zuordnung zwischen der Ein-/Ausgabebaugruppe (1) und dem Frontstecker (2) entsprechend einer Verschaltungsvorgabe hergestellt wird, wobei der Feldbusanschluss (6) derart ausgestaltet ist, das im Falle eines Austauschens der Ein-/Ausgabebaugruppe (1), wobei die alte Ein-/Ausgabebaugruppe (1) vom Frontstecker (2) getrennt wird und gegen eine neue Ein-/Ausgabebaugruppe (1') getauscht wird, die neue Ein-/Ausgabebaugruppe (1') über den Feldbusanschluss (6) der neuen Ein-/Ausgabebaugruppe (1') an ein Konfigurationssystem (5) anschließbar ist, wobei über den Feldbusanschluss (6) die individuelle Zeichenfolge der alten Ein-/Ausgabebaugruppe (1), welche in dem Konfigurationssystem (5) hinterlegt ist in eine Speichereinheit der neuen Ein-/Ausgabebaugruppe (1') weiterleitet.

4. Ein-/Ausgabebaugruppe (1) nach Anspruch 3, ausgestaltet mit einem Detektionsmittel (7), welches mit der ersten Schreib-/Leseeinheit (11) in Verbindung steht und bei einem erstmaligen Stecken des Fronsteckers (2) in die Ein-/Ausgabebaugruppe (1) die erste Schreib-/Leseeinheit (11) zum übertragen der individuellen Zeichenfolge aktiviert.

5. Ein-/Ausgabebaugruppe (1) nach Anspruch 3, wobei zwischen dem Feldbusanschluss (6) und der Speichereinheit ein Filtermittel (8) angeordnet ist, welches ausgestaltet ist die individuelle Zeichenfolge aus einem vorherrschenden Telegrammverkehr auf dem Feldbus herauszufiltern.

6. Ein-/Ausgabebaugruppe (1) nach Anspruch 5, umfassend
- ein Prüfmittel (30) und
- ein Freischaltmittel (31),
wobei das Prüfmittel (30) ausgestaltet ist zum Prüfen, ob die in der Ein-/Ausgabebaugruppe (1') hinterlegte individuelle Zeichenfolge mit der in dem Frontstecker (2) hinterlegten individuellen Zeichenfolge übereinstimmt,
wobei das Freischaltmittel (31) ausgestaltet ist bei Übereinstimmung der individuellen Zeichenfolgen, die Prozesswerte für gültig zu erklären, andernfalls die Prozesswerte für ungültig zu erklären und eine Diagnosemeldung abzusetzen.

## Claims

1. Method for operating an input/output module (1) of the control technology with a front pin (2), wherein signal lines are attached by way of a plurality of connection elements arranged on a front side of the front pin (2) in accordance with the function of the input/output module (1) according to a connection standard,
**characterised in that**
when initially inserting the front pin (2) into the input/output module (1) by way of a first read/write unit (11) arranged in the input/output module (1), an individual character string is wirelessly transmitted into a second read/write unit (12) arranged in the front pin (2), as a result of which a unique assignment is established between the input/output module (1) and the front pin (2) in accordance with the connection standard, wherein the individual character string (3) is stored in a configuration system (5) for the input/output module (1) and in a storage unit arranged in the front pin (2), wherein in the event of replacement of the input/output module (1), the old input/output module (1) is separated from the front pin (2) and is replaced by a new input/output module (1'), wherein prior to insertion of the front pin (2) into the new input/output module (1'), this is connected to the configuration system (5) and the configuration system (5) writes the individual character string into a storage unit arranged in the new input/output module (1').

2. Method according to claim 1, wherein, after insertion of the front pin (1) into the new input/output module (1'), a check is carried out by way of a testing means (30) to determine whether the individual character string in the new input/output module (1') matches the individual character string stored in the memory unit in the front pin (2) and in the event that the two individual character strings match, the new input/output module (1') activates a separation device (31), which validates process values read in by way of the signal lines, on the other hand the process values are invalidated by way of the separation means (31) and a diagnostic message is released.

3. Input/output module (1) of the control technology configured to accommodate a front pin (2) and read in process values, having a field bus connection (6),
**characterised by**
a first read/write unit (11), which is embodied to wirelessly transmit an individual character string into a second read/write unit (12) arranged in the front pin (2), as a result of which a unique assignment is established between the input/output module (1) and the front pin (2) in accordance with a connection standard, wherein the field bus connection (6) is embodied such that in the event of a replacement of the input/output module (1), wherein the old input/output module (1) is separated from the front pin (2) and is replaced by a new input/output module (1'), the new input/output module (1') can be connected to a configuration system (5) by way of the field bus connection (6) of the new input/output module (1'), wherein the individual character string of the old input/output module (1), which is stored in the configuration system (5), is routed into a storage unit of the new input/output module (1') by way of the field bus connection (6).

4. Input/output module (1) according to claim 3, configured with a detection means (7), which is connected to the first read/write unit (11) and upon initial insertion of the front pin (2) into the input/output module (2) activates the first read/write unit (11) in order to transmit the individual character string.

5. Input/output module (1) according to claim 3, wherein a filter means (8) is arranged between the field bus connection (6) and the storage unit, which is embodied to filter the individual character string out of a prevailing telegram traffic on the field bus.

6. Input/output module (1) according to claim 5, including
- a testing means (30) and
- a separation means (31),
wherein the testing means (30) is embodied to check whether the individual character string stored in the input/output module (1') corresponds with the individual character string stored in the front pin (2),
wherein the separation means (31) is embodied, upon matching of the individual character strings, to validate the process values and on the other hand to invalidate the process values and to send a diagnostic message.

## Revendications

1. Procédé pour faire fonctionner un module ( 1 ) d'entrée/sortie de la technique de commande ayant un connecteur ( 2 ) frontal, dans lequel on connecte, suivant une prescription de câblage correspondant à la fonction du module ( 1 ) d'entrée/sortie, des lignes de signal par une pluralité d'éléments de connexion mis sur une face avant du connecteur ( 2 ) frontal,
**caractérisé en ce que**
lorsqu'on enfiche pour la première fois le connecteur ( 2 ) frontal dans le module ( 1 ) d'entrée/sortie, on transmet sans fil, par une première unité ( 11 ) d'écriture/lecture disposée dans le module ( 1 ) d'entrée/sortie, une suite individuelle de signes à une deuxième unité ( 12 ) d'écriture/lecture disposée dans le connecteur ( 2 ) frontal, en ménageant ainsi, conformément à la prescription de câblage, une association univoque entre le module ( 1 ) d'entrée/sortie et le connecteur ( 2 ) frontal, dans lequel on mémorise la suite ( 3 ) individuelle de signes dans un système ( 5 ) de configuration du module ( 1 ) d'entrée/sortie et dans une unité de mémoire disposée dans le connecteur ( 2 ) frontal, dans lequel, si on remplace le module ( 1 ) d'entrée/sortie, on sépare l'ancien module ( 1 ) d'entrée/sortie du connecteur ( 2 ) frontal et on le remplace par un nouveau module ( 1' ) d'entrée/sortie en raccordant, avant d'enficher le connecteur ( 2 ) frontal dans le nouveau module ( 1' ) d'entrée/sortie, celui-ci au système ( 5 ) de configuration et le système ( 5 ) de configuration écrit la suite individuelle de signes dans une unité de mémoire disposée dans le nouveau module ( 1' ) d'entrée/sortie.

2. Procédé suivant la revendication 1, dans lequel, après avoir enfiché le connecteur ( 1 ) frontal dans le nouveau module ( 1' ) d'entrée/sortie, on contrôle, par un moyen ( 30 ) de contrôle, si la suite individuelle de signes se trouvant dans le nouveau module ( 1' ) d'entrée/sortie coïncide avec la suite individuelle de signes mémorisée dans l'unité de mémoire du connecteur ( 2 ) frontal et, si les deux suites individuelles de signes coïncident, le nouveau module ( 1' ) d'entrée/sortie active un moyen ( 31 ) de déconnexion, qui valide des valeurs de processus lues par les lignes de signal, sinon les valeurs de processus sont invalidées par le moyen ( 31 ) de déconnexion et un message de diagnostic est transmis.

3. Module ( 1 ) d'entrée/sortie de la technique de commande conformé pour recevoir un connecteur ( 2 ) frontal et lire des valeurs de processus, comprenant une connexion ( 3 ) de bus de terrain,
**caractérisé par**
une première unité ( 11 ) d'écriture/lecture, qui est conformée pour transmettre sans fil une suite individuelle de signes à une deuxième unité ( 12 ) d'écriture/lecture disposée dans le connecteur ( 2 ) frontal, en ménageant ainsi, conformément à une prescription de câblage, une association univoque entre le module ( 1 ) d'entrée/sortie et le connecteur ( 2 ) frontal, dans lequel la connexion ( 6 ) de bus de terrain est conformée de manière à ce que, dans le cas d'un remplacement du module ( 1 ) d'entrée/sortie, le module ( 1 ) d'entrée/sortie ancien étant séparé du connecteur ( 2 ) frontal et remplacé par un module ( 1' ) d'entrée/sortie nouveau, le module ( 1' ) d'entrée/sortie nouveau peut, par la connexion ( 6 ) de bus de terrain du module ( 1' ) d'entrée/sortie nouveau, être raccordé à un système ( 5 ) de configuration, dans lequel, par la connexion ( 6 ) de bus de terrain, la suite individuelle de signes du module ( 1 ) d'entrée/sortie ancien, qui est mémorisée dans le système ( 5 ) de configuration, est acheminée à une unité de mémoire du module ( 1' ) d'entrée/sortie nouveau.

4. Module ( 1 ) d'entrée/sortie suivant la revendication 3, conformé en ayant un moyen ( 7 ) de détection, qui est en liaison avec la première unité ( 11 ) d'écriture/lecture et qui, lorsque le connecteur ( 2 ) frontal est enfiché pour la première fois dans le module ( 1 ) d'entrée/sortie, active la première unité ( 11 ) d'écriture/lecture pour la transmission de la suite individuelle de signes.

5. Module ( 1 ) d'entrée/sortie suivant la revendication 3, dans lequel, entre la connexion ( 6 ) de bus de terrain et l'unité de mémoire, est disposé un moyen ( 8 ) de filtrage, qui est conformé pour filtrer la suite individuelle de signes d'un trafic de télégrammes présent sur le bus de terrain.

6. Module ( 1 ) d'entrée/sortie suivant la revendication 5, comprenant
- un moyen ( 30 ) de contrôle et
- un moyen ( 31 ) de déconnexion,
dans lequel le moyen ( 30 ) de contrôle est conformé pour contrôler si la suite individuelle de signes mémorisée dans le module ( 1' ) d'entrée/sortie coïncide avec la suite individuelle de signes mémorisée dans le connecteur ( 2 ) frontal,
le moyen ( 31 ) de déconnexion étant conformé pour, si les suites individuelles de signes coïncident, valider des valeurs de processus, sinon invalider des valeurs de processus et transmettre un message de diagnostic.
